# EUROPEAN PATENT APPLICATION

(11) **EP 0 715 491 A2**
(43) Date of publication of application: **05.06.1996**
(21) Application number: 95118375.5
(22) Date of filing: 22.11.1995
(51) Int. Cl.: H05K 5/00

(54) **Packaging system for electronic test and measurement instruments**

(30) Priority: 23.11.1994 US 344367
(71) Applicant: FLUKE CORPORATION, Everett Washington 98203 (US)
(72) Inventor: King, Indle G., Mercer Island, Washington 98040 (US); Gallagher, Patrick M., Seattle, Washington 98117 (US); Black, Michael J., Seattle, Washington 98105 (US); Stiles, William P., Bothell, Washington 98012 (US); Willows, Keith S., Seattle, Washington 98109 (US)
(74) Representative: Grünecker, Kinkeldey, Stockmair & Schwanhäusser Anwaltssozietät

(57) **Abstract**

An electronic instrument having a keyboard, a display, and electronic circuitry coupled to the keyboard and display, all of which are housed in a case. The case is relatively narrow at one end where the keyboard is accessible, and relatively wide at the other end where the display is visible. The relatively narrow portion of the case extends into the relatively wide portion of the case below the upper surface of the relatively wide portion to at least beyond the center of gravity of the electronic instrument. The electronic instrument may be grasped by a hand of a user with the thumb of the user extending along one sidewall of the relatively narrow portion of the case beneath the relatively wide portion of the case, the palm of the user extending across the bottom surface of the relatively narrow portion of the case, and the remaining fingers of the user extending along the other sidewall of the relatively narrow portion of the case beneath the relatively wide portion of the case.

## Description

### Technical Field

This invention relates to electronic instruments, and more particularly to method and apparatus for packaging an electronic test and measurement instrument having a keyboard and a display in an ergonomically optimized manner.

### Background of the Invention

Hand-held electronic devices are in common use in a variety of fields. For example, in the field of electronic test and measurement instruments, hand-held, battery-powered multimeters have been in common use for many years. These hand-held multimeters are relatively small and lightweight, and they can thus be comfortably held by a user over a long period of time.

A trend has developed in recent years to package more sophisticated electronic test and measurement instruments in a relatively small, hand-held case. For example, hand-held oscilloscopes have been manufactured and sold by Fluke Corporation of Everett, Washington. Proposals have been made to package even more sophisticated instruments, such as spectrum analyzers, distortion analyzers, etc., in a small, hand-held case. As electronic test and measurement instruments become more sophisticated, they inherently become larger and heavier, thus making them less comfortable for the user to hold for a long period of time.

The configuration of the packaging for relatively sophisticated electronic test and measurement instruments is somewhat dictated by the nature of those devices. While it is generally desirable to make the case as small as possible, it is also desirable for sophisticated electronic instruments to have a relatively large display for visually presenting wave-forms and data. Thus, at least a portion of the case for portable electronic instruments must be relatively wide to accommodate a relatively wide display. However, the remainder of the case, which generally houses switches, input jacks, and a keypad, can be substantially narrowed. As a result, a case having a relatively wide display portion and a relatively narrow keyboard portion lends itself well to packaging portable electronic test and measurement instruments.

Electronic devices of various types that are housed in a case having a relatively wide display portion and a relatively narrow keyboard portion are conventional. In use, these devices are generally held by grasping the relatively narrow keyboard portion since the relatively wide display portion is generally too wide to hold comfortably. However, it is very uncomfortable to manually support in one's hands conventional electronic devices having a relatively wide display portion and a relatively narrow keyboard portion for at least two reasons. First, if the electronic devices have a high degree of sophistication, they are, by their very nature, relatively large and heavy. However, even more important than their weight as a contributing factor to fatigue is the torque that is inevitably imparted to the hand of the user while holding such devices. In conventional electronic devices having a relatively wide display portion and a relatively narrower keyboard portion, the volume of the display portion is inherently larger than the volume of the keyboard portion. Thus, the center of gravity of the electronic device tends to be located in the display portion rather than the keyboard portion that is held by the user. As a result, when the user grasps the electronic device by the keyboard portion, the electronic device exerts a torque on the hand of the user since the center of gravity of the instrument in the display portion is spaced some distance from the keyboard portion where the electronic device is supported. In practice, the torque imparted to the hand of the user is even more fatiguing than the weight of the electronic device itself. As a result, conventional sophisticated electronic devices of the hand-held variety are generally difficult to hold for a prolonged period of time.

### Summary of the Invention

The inventive packaging system is for an electronic instrument of the type having a keyboard and a display. The packaging system includes a relatively wide display portion, a relatively narrow keyboard portion joining the display portion, and a gripping portion underlying the keyboard portion and at least a portion of the display portion. The display portion and the keyboard portion each have a generally rectangular configuration in plan and end elevational views. The display portion and the gripping portion have a common planar bottom surface so that the instrument can securely rest on a planar surface. The top surfaces of the display portion and the keyboard portion are generally planar except that the display and keyboard are recessed slightly to protect the display and prevent inadvertent actuation of the keys on the keyboard. The electronic instrument has a center of gravity located in the display portion. However, the gripping portion underlying the keyboard portion extends into the display portion at least beyond the center of gravity of the electronic instrument. The gripping portion may be grasped by a hand of a user with the thumb of the user extending along one sidewall of the gripping portion beneath the display portion, the palm of the user extending across the bottom surface of the gripping portion, and the remaining fingers of the user extending along the other sidewall of the gripping portion beneath the display portion. The sidewalls of the gripping portion preferably curve outwardly as they extend from adjacent the keyboard portion to the bottom surface of the gripping portion. The electronic device preferably also includes a battery contained within the gripping portion, and the gripping portion is preferably removable to facilitate the changing of the battery.

### Brief Description of the Drawings

Figure 1 is an isometric view of a prior art electronic device having a display and a keyboard showing the electronic device being held by a user.

Figure 2 is an isometric view of a preferred embodiment of an electronic instrument having a display and a keyboard employing the inventive packaging system.

Figure 3 is a top plan view of the electronic instrument of Figure 2.

Figure 4 is a side elevational view of the electronic instrument of Figure 2.

Figure 5 is an end elevational view of the electronic instrument of Figure 2.

Figure 6 is an isometric view of the electronic instrument of Figure 2 illustrating the manner in which it may be held by a user.

### Detailed Description of the Invention

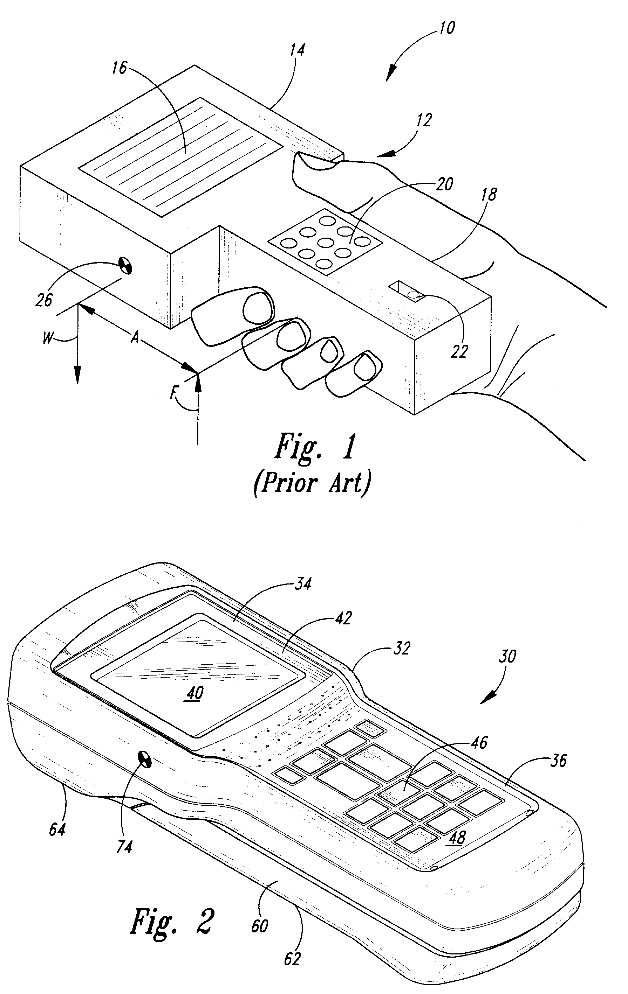

A conventional electronic instrument 10, shown in Figure 1, includes a case 12 having a relatively wide display portion 14 on which a display 16 of conventional design is visible, and a relatively narrow keyboard portion 18. A keyboard 20 of conventional design, as well as an on/off switch 22, is accessible on the upper surface of the keyboard portion 18. The thickness of the case 12 is constant throughout the display portion 14 and the keyboard portion 18. As a result, the volume of the display portion 14 is substantially larger than the volume of the keyboard portion 18. Since the packaging of the electronic circuitry is generally of approximately the same density in the display portion 14 and the keyboard portion 18, the electronic instrument 10 has a center of gravity 26 that is well into the display portion 14.

The conventional electronic instrument 10 shown in Figure 1 is normally held by the user placing his or her hand around the keyboard portion 18 of the case 12. In fact, grasping the electronic instrument 10 in this manner is the only practical way to hold it because the display portion 14 is too wide to grasp it there. As a result, the user must not only support the weight of the instrument 10, but more importantly must resist the torque exerted by the instrument on the hand of the user. For example, assume that the center of lift on the instrument 10 is located in the keyboard portion 18 at the arrow F. The weight W of the instrument 10 would then exert a downward force at the center of gravity 26. As a result, the weight would exert a torque about the center of lift F equal to the product of the weight W and the moment arm A. Even for relatively light electronic instruments 10, the torque exerted on the hand of the user can be considerable. This torque causes a great deal of fatigue when the instrument 10 is held by the user for a long period of time during use.

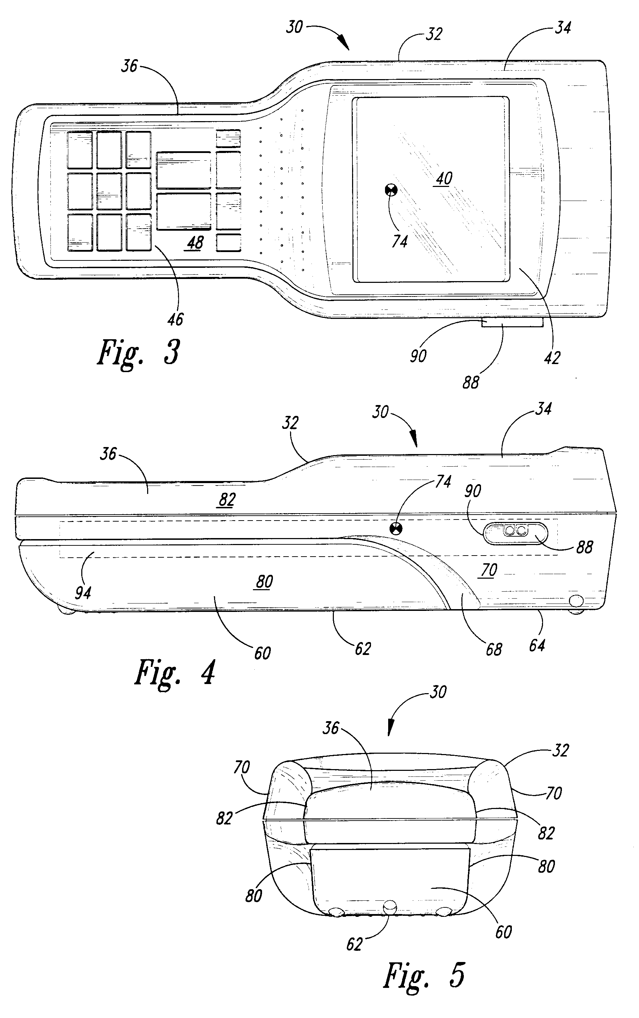

A preferred embodiment of the inventive packaging system for an electronic instrument is illustrated in Figures 2-5. The instrument 30 is shown as a portable test and measurement instrument, although the inventive packaging system is equally applicable to other instruments having a keyboard and a display. The instrument 30 includes a case 32 having a relatively wide display portion 34 and a relatively narrow keyboard portion 36. A display 40 (Figures 2 and 3) of conventional design is visible in the display portion 34 of the case 32. Since it is desirable for the display 40 to be as large as possible, the width of the display 40 is only slightly less than the width of the display portion 34. In the embodiment shown, the display 40 is recessed slightly within a top surface 42 of the display portion 34 to provide some protection to the display 40, as shown in Figures 2 and 3.

As also best shown in Figures 2 and 3, the keyboard portion 36 of the case 32 includes a keyboard 46 of conventional design. It will be understood, however, that different keyboard designs may be used depending upon the nature of the electronic instrument. All of the keys in the keyboard 46 can easily be accommodated on the top surface 48 of the keyboard portion 36 so that the keyboard portion 36 can be relatively narrow as compared to the display portion 34. In the embodiment illustrated, the keyboard 46 is recessed slightly within the top surface 48 of the keyboard portion 36 to prevent inadvertent actuation of the keys in the keyboard 46.

As best shown in Figures 2 and 4, the top surface 48 of the keyboard portion 36 is at a level that is lower than the level of the top surface 42 of the display portion 34. However, other arrangement may, of course, be used.

As best illustrated in Figures 2, 4, and 6, the case 32 also includes a grasping portion 60 that is of substantially the same width as the keyboard portion 36. The grasping portion 60 has a bottom surface 62 that is substantially flush with a bottom surface 64 of the display portion 34. Significantly, the grasping portion 60 extends the entire length of the keyboard portion 36 and into the display portion 34, thereby forming a transition surface 68 (Figures 4 and 5) extending between the display portion 34 and sidewalls 70 of the display portion 34. The distance that the grasping portion 60 extends into the display portion 34 is not critical. However, the grasping portion 60 should extend into the display portion 34 at least beneath the center of gravity 74 of the electronic device. Although not required, the grasping portion 34 may enclose batteries (not shown) for powering the instrument 30. If so, the grasping portion 34 may be made removable to facilitate changing of the batteries.

As illustrated in Figure 4, the electronic instrument 30 is substantially rectangular in side elevational view. As illustrated in Figure 5, the electronic instrument 30 is also substantially rectangular in end elevational view, although the sidewalls 70 of the display portion 34 are somewhat curved, and the grasping portion 60 has sidewalls 80 that curve outwardly as they extend from the bottom surface 62 to sidewalls 82 of the keyboard portion 36.

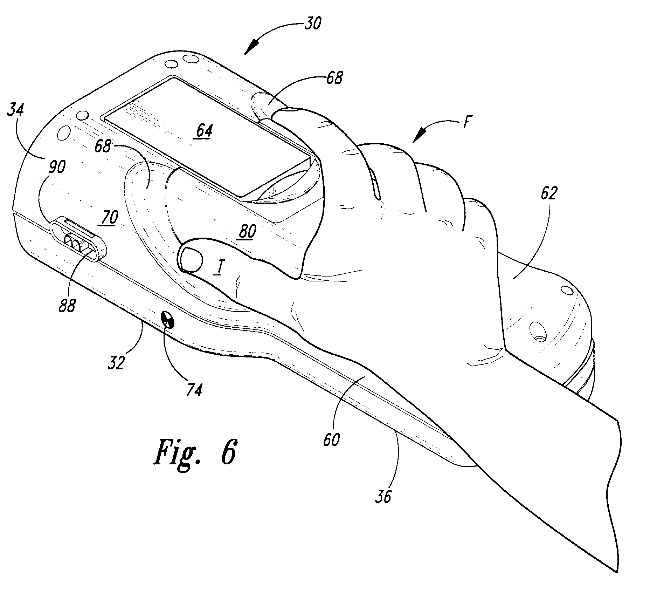

The electronic instrument 30 is specially adapted to be grasped by a user as illustrated in Figure 6. The thumb T of the user extends along one sidewall 80 of the grasping portion 60 with the end of the thumb T resting against the transition surface 68. The palm and a portion of the fingers F of the user then extend across the bottom surface 62 of the grasping portion 60 and terminate along the opposite sidewall 80 of the grasping portion 60. Note that at least some of the fingers F contact the sidewall 80 of the grasping portion 60 in the portion that extends beneath the display portion 34. In fact, at least one of the fingers F preferably contacts the transition surface 68.

It will be apparent from Figure 6 that the inventive packaging system design allows the user to not only securely hold the grasping portion 60, but, more significantly, it allows the user to place supporting fingers F directly under the center of gravity 74 of the instrument 30. It is thus unnecessary for the user to resist a relatively large torque, since the instrument 30 applies a relatively small torque to the hands of the user because the hand can support the instrument 30 directly beneath the center of gravity 74.

As shown in Figures 2-4, plug jack 88 is located on the right sidewall 70 of the display portion 34. The plug jack 88 is substantially recessed, and it is surrounded by an outwardly projecting wall 90. The wall 90 in combination with the recessed nature of the jack 88 tends to prevent plugs (not shown) inserted into the jack 88 from being inadvertently sheared off. The jack 88 is connected to an electronic circuit 94 (Figure 4) within the case 32 that is also connected to the display 40 and keyboard 46. However, the jack 88 is not an essential aspect of the present invention. Therefore, different jack designs may be used, and the instrument 30 may entirely omit a jack of any type.

The inventive packaging system is easily adaptable to a wide variety of electronic measuring instruments having displays 34 of varying size and configuration as well as to keyboards 46 varying in configuration and number. Moreover, the length and thickness of the case 32 can be varied as desired depending upon the size of the electronic components that must be accommodated within the case 32.

From the foregoing, it will be evident that, although specific embodiments of the invention have been described herein for purposes of illustration, various modifications may be made without deviating from the spirit and scope of the invention.

## Claims

1. A packaging system for an electronic instrument of the type having a keyboard and a display, said packaging system comprising:
a relatively wide display portion having a generally rectangular configuration in plan and end elevational views, said display portion having a generally planar bottom surface and a top face on which said display appears;
a relatively narrow keyboard portion having a generally rectangular configuration in plan and end elevational views, said keyboard portion having a top face on which said keyboard is accessible, said keyboard portion and said display portion forming a unitary case, said instrument having a center of gravity that is located in said display portion;
a gripping portion underlying said keyboard portion and extending partly into said display portion at least beyond the center of gravity of said case, said gripping portion having a bottom surface that is substantially flush with the bottom surface of said display portion, a width that is not substantially larger than the width of said keyboard portion so that the width of said display portion is reduced in the area where said gripping portion underlies said display portion, and sidewalls extending from the side edges of said gripping portion adjacent said keyboard portion to the bottom surface of said gripping portion, the reduced width area of said display portion having formed therein a transition surface joining each sidewall of said gripping portion to respective sidewalls of said display portion whereby said electronic instrument may be held by grasping said gripping portion with a thumb of a user extending along one sidewall of the gripping portion to contact the transition surface, the palm of the user extending across the bottom surface of the gripping portion, and the remaining fingers of the user extending along the other sidewall of the gripping portion.

2. The packaging system of claim 1 wherein the sidewalls of said gripping portion curve outwardly as they extend from adjacent said keyboard portion to the bottom surface of said gripping portion.

3. The packaging system of claim 1 wherein each of said transition surfaces curves smoothly within the reduced width area of said display portion from a surface parallel to the bottom surface of said display portion to a surface extending toward the bottom surface of said display portion away from said keyboard portion.

4. The packaging system of claim 1 wherein said display and keyboard are mounted within respective recessed areas on the top faces of said display portion and said keyboard portion, respectively.

5. The packaging system of claim 1 further including a battery contained within said gripping portion, and wherein said gripping portion is removable from said display and keyboard portions to facilitate the changing of said battery.

6. An electronic instrument, comprising:
an electronic display for providing a visual output of information from said electronic instrument;
a keyboard for entering information into the electronic instrument;
an electronic circuit coupled to said electronic display and to said keyboard, said electronic circuit receiving information from said keyboard and supplying information to said electronic display;
a case having a relatively wide display portion containing said electronic display and a relatively narrow keyboard portion containing said keyboard; said display and keyboard portions each having a generally rectangular configuration in plan and end elevational views, said display portion having a generally planar bottom surface and a top face on which said display appears, and said keyboard portion having a top face on which said keyboard is accessible, said instrument having a center of gravity that is located in said display portion, said case further including a gripping portion underlying said keyboard portion and extending partly into said display portion at least beyond the center of gravity of said instrument, said gripping portion having a bottom surface that is substantially flush with the bottom surface of said display portion, a width that is not substantially larger than the width of said keyboard portion so that the width of said display portion is reduced in the area where said gripping portion underlies said display portion, and sidewalls extending from the side edges of said gripping portion adjacent said keyboard portion to the bottom surface of said gripping portion, the reduced width area of said display portion having formed therein a transition surface joining each sidewall of said gripping portion to respective sidewalls of said display portion whereby the electronic instrument may be held by grasping said gripping portion with a thumb of the user extending along one sidewall of the gripping portion to contact the transition surface, the palm of the user extending across the bottom surface of the gripping portion, and the remaining fingers of the user extending along the other sidewall of the gripping portion.

7. The electronic instrument of claim 6 wherein the sidewalls of said gripping portion curve outwardly as they extend from adjacent said keyboard portion to the bottom surface of said gripping portion.

8. The electronic instrument of claim 6 wherein each of said transition surfaces curves smoothly within the reduced width area of said display portion from a surface parallel to the bottom surface of said display portion to a surface extending toward the bottom surface of said display portion away from said keyboard portion.

9. The electronic instrument claim 6 wherein said display and keyboard are mounted within respective recessed areas on the top faces of said display portion and said keyboard portion, respectively.

10. The electronic instrument of claim 6 further including a battery contained within said gripping portion, and wherein said gripping portion is removable from said display and keyboard portions to facilitate the changing of said battery.

11. An electronic instrument having a keyboard, a display, and electronic circuitry coupled to the keyboard and display, said electronic instrument further including a case enclosing said keyboard, display, and electronic circuitry, said case having a generally rectangular configuration in plan view, side elevational view, and end elevational view, said case being relatively narrow in plan view at one end and relatively wide in plan view at the other end, said keyboard being accessible on an upper surface of the relatively narrow end of the case and said display being visible on an upper surface of the relatively wide end of the case, the relatively narrow portion of said case extending into the relatively wide portion of said case below the upper surface of the relatively wide portion to at least beyond the center of gravity of the electronic instrument whereby said electronic instrument may be grasped by a hand of a thumb of the user extending along one sidewall of the relatively narrow portion of said case to a point beneath the relatively wide portion of said case, the palm of the user extending across the bottom surface of the relatively narrow portion of said case, and the remaining fingers of the user extending along the other sidewall of the relatively narrow portion of said case to a point beneath the relatively wide portion of said case.

12. The electronic instrument of claim 11 wherein the sidewalls of the relatively narrow portion of said case bow outwardly.

13. The electronic instrument of claim 11 wherein said display and keyboard are mounted within respective recessed areas on the upper surface of said case.

14. The electronic instrument of claim 11 further including a battery contained within the relatively narrow portion of said case, and wherein the lower part of the relatively narrow portion of said case is removable from the upper part of the relatively narrow portion of said case to facilitate the changing of said battery.
